# EUROPEAN PATENT APPLICATION

(11) **EP 4 456 141 A1**
(43) Date of publication of application: **30.10.2024**
(21) Application number: 23170601.1
(22) Date of filing: 28.04.2023
(51) Int. Cl.: H01L 29/06, H01L 29/872, H01L 29/16

(54) **IMPROVED CONTROL OF THE FORWARD AND REVERSE CHARACTERISTICS OF VERTICALLY ORIENTED SEMICONDUCTOR DEVICES**

(71) Applicant: Nexperia B.V., 6534 AB Nijmegen (NL)
(72) Inventor: El-Zammar, Georgio, Hamburg (DE); Böttcher, Tim, 22529 Hamburg (DE); Mazzillo, Massimo Cataldo, Hamburg (DE); Habenicht, Sönke, 22529 Hamburg (DE)
(74) Representative: Pjanovic, Ilija

(57) **Abstract**

A vertically oriented semiconductor device comprising a semiconductor body, the semiconductor device having a first major surface and comprises a substrate, a first region provided on said substate and having a first conductivity type, a metal layer provided on top of said first region, such that a Schottky junction is provided between said first region and said metal layer, two, laterally spaced, islands, extending from said first major surface downward into said semiconductor body, said islands having said second conductivity type, wherein said first region comprises an epitaxial layer provided on said substrate, and an N-current spreading, NCS, layer provided on top of said epitaxial layer, wherein a doping concentration of said epitaxial layer is lower than a doping concentration of said NCS layer, and wherein said NCS layer at least covers sidewalls of said two islands

## Description

### Technical field

The present disclosure is generally related to the field of vertically oriented semiconductor and, more specifically, to vertically oriented semiconductors that have a Schottky junction.

### Background

Due to improved electrical and physical properties of silicon carbide, SiC, material, such as wide bandgap, high critical breakdown electric field, and high thermal conductivity, SiC power devices have great potential for high voltage, high-frequency, and high-temperature applications.

The past two decades have witnessed tremendous progress of the SiC power diode towards commercialization and application with relevant implications in terms of costs, die size and manufacturability issues especially on high voltage devices. The SiC Schottky barrier diode, SBD, was first commercialized due to its low onset voltage and negligible reverse recovery, compared with the p-i-n diode.

However, the large leakage current under high blocking voltage limits its performance and application. The junction barrier Schottky, JBS, diode, trench junction barrier Schottky, TJBS, diode, trench Metal Oxide Semiconductor, MOS, barrier Schottky, TMBS, diode, and dual-metal Schottky diode were developed to address the above problem and to achieve the trade-off between forward voltage drop and reverse leakage current.

However, all these designs are characterized by a significant higher technology complexity with consequent increase of manufacturability issues, lead time and costs. To further improve diodes' characteristics, SiC merged p-i-n Schottky, MPS, diodes were proposed to endure high surge current stress.

Despite the improvements brought by the new designs, all the power diodes including Schottky junctions still show consistent limitations due to high leakage current, especially at high temperature. If not properly controlled, the leakage increase can have a relevant impact on the reverse voltage blocking capability and reliability, resulting in yield loss and premature fails.

The surge level in vertically oriented semiconductor devices is a reliability concern and requires an important attention when designing the such devices. Surge current capability, which represents the reliability of power devices under high current pulses, is one of the parameters for device ruggedness since high current pulses are common at the starting-up of electrical equipment or during accidental circuit failures.

One of the downsides of known vertically oriented semiconductor devices is relates to the on-resistance and the surge performance.

### Summary

It is an object of the present disclosure to provide for a vertically oriented semiconductor device, having a junction, and that allows to inject minority carriers faster and results in improving the on-resistance and the surge performance.

In a first aspect of the present disclosure, there is provided vertically oriented semiconductor device comprising a semiconductor body, the semiconductor device having a first major surface and comprises:
- a substrate;
- a first region provided on said substate and having a first conductivity type;
- a metal layer provided on top of said first region, such that a Schottky junction is provided between said first region and said metal layer;
- two, laterally spaced, islands, extending from said first major surface downward into said semiconductor body, said islands having said second conductivity type;

wherein said first region comprises:
   - an epitaxial layer provided on said substrate, and
   - an N-current spreading, NCS, layer provided on top of said epitaxial layer,
wherein a doping concentration of said epitaxial layer is lower than a doping concentration of said NCS layer, and
wherein said NCS layer at least covers sidewalls of said two islands.

The inventors have found that it may be beneficial to have an additional layer, i.e. the NCS layer, covering the sidewalls. This is explained in more detail further below. The doping concentration of the NCS layer is higher compared to the doping concentration of the epitaxial layer.

The NCS layer may extend laterally between the sidewalls of the two islands.

This would mean that, in an example, at least a large part of the bottom side of the two islands directly border the epitaxial layer.

The NCS layer is then provided only in between the islands to trigger the junction, i.e. the interface between the corresponding island and the epitaxial layer, earlier. This is because the doping concentration in the epitaxial layer is lower compared to the doping concentration in the NCS layer.

In the below, the first conductivity type is considered to be of the N-type and the second conductivity type is considered to be of the P-type.

A PN junction is formed at the bottom side of the corresponding island by bringing together the P-type semiconductor material of the island and the N-type semiconductor material of the epitaxial layer. When these two materials come into contact, electrons from the N-type material diffuse into the P-type material, and holes from the P-type material diffuse into the N-type material.

This creates a region around the interface where electrons and holes recombine, creating a depletion zone with a net electric field.

The width of this depletion zone, and therefore the behaviour of the PN junction, depends on the doping concentration of the P and N-type materials. When the N doping concentration is reduced, there are fewer free electrons in the N-type material to diffuse across the interface and neutralize the holes in the P-type material.

This means that the depletion region widens more quickly, and the PN junction begins to conduct at a lower voltage than it would with higher N doping.

In other words, reducing the N doping concentration increases the width of the depletion region, which makes it easier for the PN junction to conduct electricity.

As such, the PN junction is triggered earlier.

In a further example, the NCS layer is provided around at least one island thereby surrounding said at least one island such that in a lateral cross-section said at least one island is bordered by said NCS layer, and said NCS layer is bordered by said epitaxial layer.

For example, the metal layer is provided on top of said epitaxial layer such that the NCS layer is not extended laterally in between the two islands.

The NCS layer is then used such to allow to maintain a minimum resistance to the P material of the island and to slightly delay the depletion of the N-doped layer, i.e. the epitaxial layer, in the reverse direction. It further allows to improve the Reduced Surface Field, RESURF, effect between the islands.

On top of the above, an improved Schottky contact is realized with a reduced N-doping thereby lowering the voltage at a nominal current.

In an example, a thickness of said NCS layer equals a depth of any of said two islands +/- 30%, preferably +/- 10%.

In a further example, any of said two islands comprise:
- a top part bordering said metal layer
- a bottom part at least party covering said top part,
wherein a doping concentration of said top part is higher than a doping concentration of said bottom part.

The bottom part may fully cover the top part or may partly cover the top part.

The above would entail that in a lateral cross-section said top part is bordered by said bottom part, and said bottom part is bordered by said NCS layer.

In another example, a first lateral cross-section said top part is bordered by said NCS, and said NCS is bordered by said NCS layer and a second lateral cross-section, deeper in said semiconductor body compared to said first lateral cross-section, said top part is bordered by said bottom part, and said bottom part is bordered by said NCS layer.

In a semiconductor device, the epitaxial layer may be a thin layer of semiconductor material that is deposited on top of the substrate using a process called epitaxy. This layer has a carefully controlled thickness and doping concentration, and may be designed to have specific electrical properties that are different from the substrate material.

The epitaxial layer may play a role in the performance of semiconductor devices by providing a platform for the formation of active devices such as transistors and diodes, as well as providing a means for controlling the electrical properties of the device.

NCS means N current spread layer. It is usually implanted and not deposited by epitaxy. It has a slightly higher doping than the epitaxial layer and it is added with the purpose to reduce, at low bias, the depleted region thickness in the area between the P islands, allowing for a reduction of the channel resistance. In other words, allowing more current to flow from the Schottky top anode contact to the bottom cathode and reducing in this way the conduction losses in forward bias.

In a typical example,
- a depth of said NCS layer into said semiconductor body is between 1300nm - 1500nm.
- a depth of any of said islands into said semiconductor body is between 200nm - 1800nm.

In a further example, a depth of said bottom part into said semiconductor body is between 200nm - 1800nm, and a depth of said top part into said semiconductor body is between 50n - 400nm.

In yet another example, a doping of said first region is between any of 1e16cm3 and 5e17cm3, and a doping of any of said two islands is between 1e17cm3 and 5e20cm3.

In an example, the semiconductor device is any of:
- a Merged PIN Schottky diode;
- a Schottky diode.

In yet another example, the semiconductor body comprises Silicon Carbide, SiC.

In an even further example, the first conductivity is N-type conductivity and wherein the second conductivity is P-type conductivity.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 discloses a Merged PIN Schottky diode in accordance with the present disclosure;
Fig. 2 discloses a further Merged PIN Schottky diode in accordance with the present disclosure;
Fig. 3 discloses yet another Merged PIN Schottky diode in accordance with the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

The figures, and the description to the figures, are related to a Merged PIN Schottky diode. It is however noted that the present application is also applicable to other vertically oriented semiconductor devices.

A Merged PIN Schottky diode is a semiconductor device that combines the functionality of a PIN diode and a Schottky diode into a single structure. This type of diode is typically used in high-frequency and high-power applications where low forward voltage drop and fast switching speed are required.

The PIN diode is a three-layer structure consisting of a p-type layer sandwiched between two n-type layers. The Schottky diode, on the other hand, is a metal-semiconductor junction that has a low forward voltage drop due to the absence of a p-n junction.

In a Merged PIN Schottky diode, the Schottky metal contact is formed on the top layer of the PIN diode, creating a Schottky junction. This configuration allows the device to have a low forward voltage drop similar to a Schottky diode, while also providing the high-frequency capabilities of a PIN diode.

Merged PIN Schottky diodes are commonly used in applications such as mixers, detectors, and frequency multipliers. They are also used in power supplies, where they can reduce the size and weight of the device by eliminating the need for a bulky rectifier.

Overall, the Merged PIN Schottky diode offers a unique combination of low forward voltage drop and high-frequency capabilities, making it a useful device in a wide range of electronic applications.

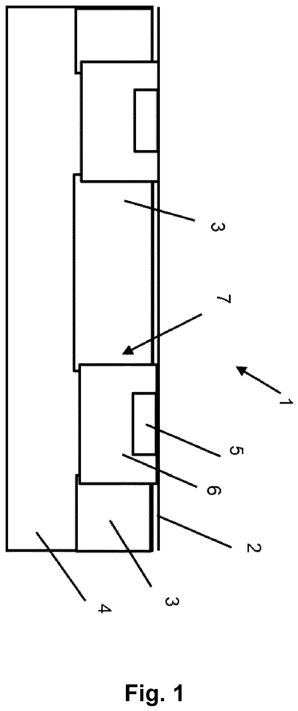

Figure 1 discloses a Merged PIN Schottky diode 1 in accordance with the present disclosure.

The Merged PIN Schottky diode 1 is vertically oriented in the sense that the current flows vertically, i.e. from the top side to the bottom side. The diode 1 comprises a semiconductor body, for example SiC or silicon or anything alike.

A substrate (not shown) is provided at the bottom side of the vertically oriented semiconductor device 1. On top of the substrate, a first region is provided, wherein the first region has a first conductivity type. The first conductivity type is, for example, of the N-type.

A metal layer 2 is provided on top of the first region, such that a Schottky junction is provided between the first region and the metal layer 2.

Two, laterally spaced, islands 5, 6 are provided, which extend from the first major surface downward into the semiconductor body, wherein the islands 5, 6 have the second conductivity type, the second conductivity type being opposite to the first conductivity type. That is, the second conductivity type is of the P-type.

The first region comprises two different layers. An epitaxial layer 4 is provided on top of the substrate and an N-current spreading, NCS, layer 3 is provided on top of the epitaxial layer.

The doping concentration of the epitaxial layer 4 is lower than a doping concentration of the NCS layer 3.

It was the insight of the inventors that it is preferred to ensure that the NCS layer 3 at least covers sidewalls 7 of the two islands 5, 6.

Figure 1 discloses sidewalls 5, 6 that comprise:
- a top part 5 bordering said metal layer
- a bottom part 6 at least party covering said top part 5,
wherein a doping concentration of said top part 5 is higher than a doping concentration of said bottom part 6.

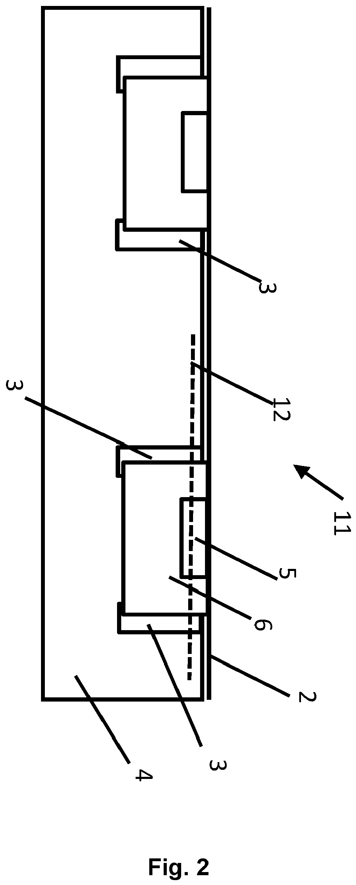

Figure 2 discloses another example of a Merged PIN Schottky diode 11 in accordance with the present disclosure.

It is noted that the same reference numerals are used, in view of figure 1, to improve the readability of the present disclosure.

The difference here is that the NCS layer does not extend laterally between the two islands. In a lateral cross-section, as indicated with reference numeral 12, the top part 5 is bordered by said bottom part 6, and said bottom part 6 is bordered by said NCS layer 3. Further, the NCS layer does not cover the bottom side of any of the islands.

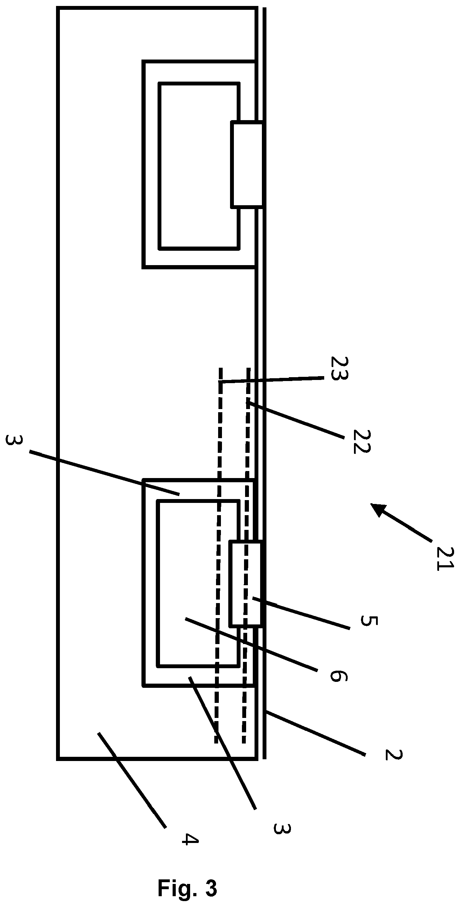

Figure 3 discloses yet another example of a Merged PIN Schottky diode 21 in accordance with the present disclosure.

In a first lateral cross-section, as indicated by the reference numeral 22, said top part 5 is bordered by said NCS 3, and said NCS 3 is bordered by said epitaxial layer.
- in a second lateral cross-section, as indicated with reference numeral 23, deeper in said semiconductor body compared to said first lateral cross-section, said top part 5 is bordered by said bottom part 6, and said bottom part 6 is bordered by said NCS layer 3.

To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A vertically oriented semiconductor device comprising a semiconductor body, the semiconductor device having a first major surface and comprises:
- a substrate;
- a first region provided on said substate and having a first conductivity type;
- a metal layer provided on top of said first region, such that a Schottky junction is provided between said first region and said metal layer;
- two, laterally spaced, islands, extending from said first major surface downward into said semiconductor body, said islands having said second conductivity type;
wherein said first region comprises:
- an epitaxial layer provided on said substrate, and
- an N-current spreading, NCS, layer provided on top of said epitaxial layer,
wherein a doping concentration of said epitaxial layer is lower than a doping concentration of said NCS layer, and
wherein said NCS layer at least covers sidewalls of said two islands.

2. A vertically oriented semiconductor device in accordance with claim 1, wherein said NCS layer laterally extends between said sidewalls of said two islands.

3. A vertically oriented semiconductor device in accordance with claim 2, wherein bottom parts of said two islands border said epitaxial layer.

4. A vertically oriented semiconductor device in accordance with any of the previous claims, wherein said NCS layer is provided around at least one island thereby surrounding said at least one island such that in a lateral cross-section said at least one island is bordered by said NCS layer, and said NCS layer is bordered by said epitaxial layer.

5. A vertically oriented semiconductor device in accordance with claim 4, wherein said metal layer is provided on top of said epitaxial layer.

6. A vertically oriented semiconductor device in accordance with any of the claims 4-5, wherein a thickness of said NCS layer equals a depth of any of said two islands +/- 30%, preferably +/- 10%.

7. A vertically oriented semiconductor device in accordance with any of the previous claims, wherein any of said two islands comprise:
- a top part bordering said metal layer
- a bottom part at least partly covering said top part,
wherein a doping concentration of said top part is higher than a doping concentration of said bottom part.

8. A vertically oriented semiconductor device in accordance with claim 7, wherein said bottom part fully covers said top part.

9. A vertically oriented semiconductor device in accordance with claim 7, wherein said bottom part partly covers said top part.

10. A vertically oriented semiconductor device in accordance with claim 8 in combination with claim 5, wherein
- in a lateral cross-section said top part is bordered by said bottom part, and said bottom part is bordered by said NCS layer.

11. A vertically oriented semiconductor device in accordance with claim 9 in combination with claim 5, wherein
- in a first lateral cross-section said top part is bordered by said NCS, and said NCS layer is bordered by said epitaxial layer;
- in a second lateral cross-section, deeper in said semiconductor body compared to said first lateral cross-section, said top part is bordered by said bottom part, and said bottom part is bordered by said NCS layer.

12. A vertically oriented semiconductor device in accordance with any of the previous claims, wherein
- a depth of said NCS layer into said semiconductor body is between 500nm - 1500nm.
- a depth of any of said islands into said semiconductor body is between 200nm - 1800nm.

13. A vertically oriented semiconductor device in accordance with claim 12 in combination with claim 10, wherein:
- a depth of said bottom part into said semiconductor body is between 200nm - 1800nm, and
- a depth of said top part into said semiconductor body is between 50nm - 400nm.

14. A vertically oriented semiconductor device in accordance with any of the previous claims, wherein:
- a doping of said first region is between any of 1e16cm-3 and 5e17cm-3;
- a doping of any of said two islands is between 5e17cm-3 and 5e20cm-3.

15. A vertically oriented semiconductor device in accordance with any of the previous claims, wherein said semiconductor device is any of:
- a Merged PIN Schottky diode;
- a Schottky diode.

16. A vertically oriented semiconductor device in accordance with any of the previous claims, wherein said semiconductor body comprises Silicon Carbide, SiC.

17. A vertically oriented semiconductor body in accordance with any of the previous claims, wherein the first conductivity is N-type conductivity and wherein the second conductivity is P-type conductivity.
